# FASCICULE DE BREVET EUROPEEN

(11) **EP 2 005 473 B1**
(45) Date de publication et mention de la délivrance du brevet: **07.04.2010**
(21) Numéro de dépôt: 07704549.0
(22) Date de dépôt: 13.02.2007
(51) Int. Cl.: H01L 27/142, H01L 31/18, H01L 31/0236

(54) **COUCHE CONDUCTRICE TRANSPARENTE ET TEXTUREE ET SON PROCEDE DE REALISATION**
TEXTURIERTE TRANSPARENTE LEITFÄHIGE SCHICHT UND HERSTELLUNGSVERFAHREN DAFÜR
TEXTURED TRANSPARENT CONDUCTIVE LAYER AND METHOD OF PRODUCING IT

(30) Priorité: 30.03.2006 EP 06112013
(43) Date de publication de la demande: 24.12.2008
(73) Titulaire: Université de Neuchâtel, 2000 Neuchâtel (FR)
(72) Inventeur: BAILAT, Julien, CH-2855 Glovelier (CH); BALLIF, Christophe, CH-2000 Neuchâtel (CH); DOMINE, Didier, CH-2000 Neuchâtel (CH)
(74) Mandataire: GLN
(86) Numéro de dépôt international: PCT/EP2007/051375
(87) Numéro de publication internationale: WO 2007/113037

(56) Documents cités:
- EP-A- 0 698 929
- EP-A- 1 443 527
- DE-A1- 19 713 215
- US-A- 4 532 537
- US-A1- 2002 050 289
- US-A1- 2002 134 425
- US-A1- 2004 235 286
- PATENT ABSTRACTS OF JAPAN vol. 012, no. 191 (C-501), 3 juin 1988 (1988-06-03) & JP 62 297462 A (TOYOTA MOTOR CORP), 24 décembre 1987 (1987-12-24)
- IP K ET AL: "Effect of high-density plasma etching on the optical properties and surface stoichiometry of ZnO" APPLIED PHYSICS LETTERS, AIP, AMERICAN INSTITUTE OF PHYSICS, MELVILLE, NY, US, vol. 81, no. 19, 4 novembre 2002 (2002-11-04), pages 3546-3548, XP012032371 ISSN: 0003-6951
- KENJI YAMAMOTO: "Very Thin Film Crystalline Silicon Solar Cells on Glass Substrate Fabricated at Low Temperature" IEEE TRANSACTIONS ON ELECTRON DEVICES, IEEE SERVICE CENTER, PISACATAWAY, NJ, US, vol. 46, no. 10, octobre 1999 (1999-10), XP011017068 ISSN: 0018-9383

## Description

La présente invention se rapporte au domaine des dispositifs photoélectriques. Elle concerne, plus particulièrement, une couche conductrice transparente déposée sur un substrat destiné à un dispositif photoélectrique en couches minces. Une telle couche est plus souvent appelée, par les spécialistes, couche ou électrode TCO (de l'anglais transparent conductive oxide). L'invention concerne également un procédé de réalisation de cette électrode.

La présente invention trouve une application particulièrement intéressante pour la réalisation de cellules photovoltaïques destinées à la production d'énergie électrique, mais elle s'applique également, de manière plus générale, à toute structure dans laquelle un rayonnement lumineux est converti en un signal électrique, telle que les photodétecteurs.

Dans l'état actuel de la technique, les dispositifs photoélectriques en couches minces, ayant typiquement une épaisseur inférieure à 10µm, sont constitués d'un substrat transparent ou non, souple ou rigide, et, déposée sur celui-ci, d'une couche photoélectriquement active formée d'un matériau semi-conducteur inorganique ou, plus rarement, organique, et contactée de part et d'autre par deux électrodes dont l'une au moins est transparente. La couche de semi-conducteur est généralement constituée de l'empilement d'une couche de type p, d'une couche active de type intrinsèque, et d'une couche de type n, formant ensemble une jonction p-i-n ou n-i-p. Le matériau utilisé est principalement le silicium amorphe ou microcristallin hydrogéné. Dans le cas d'une couche photoélectriquement active organique, celle-ci est généralement constituée de l'empilement d'une couche de type p et d'une couche de type n. Le matériau utilisé est alors, par exemple, un polymère.

Afin de limiter les coûts de fabrication du dispositif photoélectrique, la couche active intrinsèque doit être relativement mince (entre 100nm et quelques microns). Cependant, une telle couche conduit à une quantité de lumière absorbée faible, particulièrement pour les matériaux à gap indirect, tels que le silicium microcristallin et, par conséquent, à une efficacité réduite. Pour compenser cet effet, il est donc nécessaire d'augmenter au maximum le trajet optique de la lumière au sein de la couche intrinsèque. Ceci est généralement réalisé par l'emploi d'un substrat - ou couche - TCO texturé, permettant de diffuser ou de diffracter la lumière incidente et, ainsi, d'augmenter la longueur du chemin de la lumière dans la couche active.

Le document DE 197 13 215 décrit une cellule solaire dont le substrat est recouvert d'une couche TCO, avantageusement en oxyde de zinc (ZnO), formée par pulvérisation cathodique dans une atmosphère d'argon à partir d'une cible de ZnO dopée à l'aluminium. Afin de conférer une rugosité à cette couche TCO, normalement sans aspérités, elle est attaquée soit par un procédé chimique à l'aide d'une solution acide, soit par un procédé électrochimique (attaque anodique ou attaque ionique réactive). L'attaque peut se faire pendant ou après le dépôt de la couche TCO.

Un tel procédé souffre cependant de plusieurs inconvénients. Tout d'abord, l'équipement de pulvérisation cathodique et les cibles nécessaires sont relativement coûteux, ce qui surcharge de manière sensible le prix de revient des cellules ainsi produites. Deuxièmement, l'attaque de la couche TCO est délicate. Elle doit donc être dosée avec soin, faute de quoi on obtient, pour la couche TCO, une morphologie de surface, notamment de larges cratères, qui n'est pas favorable au piégeage optique, ainsi que des interruptions qui sont peu propices à une bonne croissance ultérieure de la couche photoélectrique.

Le document JP 62-297 462 propose de déposer une couche TCO par évaporation - et non par voie chimique - et d'interrompre cette opération pour adoucir la surface de la couche par une attaque au moyen d'un plasma d'argon.

Une telle approche, appliquée à la réalisation d'une cellule photovoltaïque, conduirait, à cause du dépôt par évaporation, à un film de très faible rugosité, nettement insuffisante, en tout cas, pour lui conférer une capacité de piégeage optique acceptable pour cette application. L'action d'un plasma d'argon sur la couche déposée servirait à réduire encore la rugosité de la couche, ce qui la rendrait quasi incapable d'assurer la fonction de piégeage optique d'une cellule photovoltaïque.

Une indication de la capacité de piégeage optique d'une couche est donnée par le « Haze factor » qui prend la valeur 0% lorsqu'aucune partie de la lumière incidente n'est diffusée et la valeur 100% lorsque toute la lumière reçue est diffusée. Bien entendu, le « Haze factor » d'une cellule solaire doit avoir une valeur aussi élevée que possible, typiquement de 10% au minimum. Or, les valeurs fournies dans le document JP susmentionné sont respectivement de 2 à 5% avant l'action d'un plasma d'argon et de 0,5% après le traitement. Ces valeurs montrent bien que l'attaque par plasma d'argon d'une couche déposée par évaporation ne vise pas le domaine des cellules photovoltaïques.

Le document EP 1 443 527 décrit une couche TCO texturée présentant une morphologie de surface formée d'une alternance de creux plats qui possèdent de nombreuses micro-aspérités ayant une base de 0,1 à 0,3 µm, une hauteur de 0,05 à 0,2 µm et un pas (distance entre les sommets) de 0,1 à 0,3 µm. De telles micro-aspérités sont toutefois peu propices à une bonne croissance ultérieure de la couche photoélectrique. De plus, en raison de leur petite taille, elles augmentent peu le piégeage de la lumière dans la gamme intéressante (rouge et infra-rouge). Par ailleurs, le fait que les creux soient plats a l'inconvénient d'augmenter la réflexion de la lumière et, de ce fait, de diminuer la lumière injectée dans le dispositif photovoltaïque, réduisant ainsi d'autant le courant photo-généré.

L'un des buts de la présente invention est de fournir une couche TCO ayant une bonne capacité de piégeage de la lumière tout en assurant une croissance ultérieure satisfaisante de la couche photoélectrique.

De façon plus précise, l'invention concerne une couche conductrice transparente texturée déposée sur un substrat destiné à un dispositif photoélectrique, et présentant une morphologie de surface formée d'une alternance de bosses et de creux. Selon l'invention, cette couche est caractérisée en ce que :
- ses creux ont un fond arrondi dont le rayon de courbure est supérieur à 25 nm environ,
- lesdits creux sont pratiquement lisses, c'est-à-dire que s'ils présentent des micro-aspérités, celles-ci ont, en moyenne, une hauteur inférieure à 5 nm, et
- ses flancs forment, avec le plan du substrat, un angle dont la médiane de la valeur absolue est comprise entre 30° et 75° environ.

L'invention concerne également un procédé de réalisation, sur un substrat destiné à un dispositif photoélectrique, d'une couche conductrice transparente texturée. Ce procédé comporte les opérations essentielles suivantes :
- dépôt sur le substrat, par voie chimique, d'une couche rugueuse diffusant la lumière, et
- attaque de cette couche rugueuse par un plasma de manière à obtenir une couche présentant une morphologie de surface formée d'une alternance de bosses et de creux,
   - lesdits creux ayant un fond arrondi dont le rayon est supérieur à 25 nm ;
   - lesdits creux étant pratiquement lisses, c'est-à-dire que, s'ils présentent des micro-aspérités, celles-ci ont, en moyenne, une hauteur inférieure à 5 nm ; et
   - les flancs de la couche formant, avec le plan du substrat, un angle dont la médiane de la valeur absolue est comprise entre 30° et 75,
   afin de lui conférer une morphologie propice à une bonne croissance ultérieure d'une couche photoélectrique déposée sur elle, sans diminution significative de son pouvoir de diffuser la lumière incidente.

D'autres caractéristiques de l'invention ressortiront de la description qui va suivre, faite en regard du dessin annexé, dans lequel :
- la figure 1 représente le profil (hauteur en fonction de la position) d'une couche de ZnO déposée par voie chimique, respectivement avant (a) et après (b) son attaque par un plasma d'argon;
- la figure 2 est un graphe donnant l'évolution de la rugosité Rᵣₘₛ de cette couche en fonction de la durée t de son attaque ;
- les figures 3 et 4 sont des vues en plan de cette couche avant et après son attaque ; et
- la figure 5 est un graphe montrant l'efficacité η, en fonction de la durée t d'attaque au plasma, d'un dispositif photoélectrique doté d'une telle couche.

Avant de fournir une description de la couche TCO selon l'invention et de son procédé de réalisation, on rappellera qu'un dispositif photoélectrique, qu'il s'agisse d'une cellule solaire ou d'un photodétecteur, se caractérise par son rendement de conversion η et sa capacité de piégeage optique, le premier dépendant de la deuxième, pour autant que la collection du courant photo-généré soit bonne.

Le rendement de conversion η d'un tel dispositif est donné par le rapport entre la puissance électrique fournie par le dispositif et la puissance lumineuse reçue, la puissance fournie étant égale au produit :
Courant de court-circuit (I_{sc}) x Tension de circuit ouvert (V_{oc}) x Fill factor (FF).

Une bonne indication de la capacité de piégeage optique est donnée par la densité de photo-courant (Iᵢₙᵥ) fournie par la cellule sous tension inverse, cette tension inverse permettant d'extraire tous les porteurs photo-générés et d'évaluer ainsi la densité de courant maximum du dispositif, indépendamment des valeurs de V_{oc} et FF

Le procédé selon l'invention comprend deux opérations essentielles, réalisées sur un substrat destiné à un dispositif photoélectrique, qui peut être en plastique, en métal, en verre ou en tout autre matériau isolant ou conducteur, flexible ou rigide.

La première opération est le dépôt, sur le substrat, d'une couche d'oxyde transparent conducteur TCO, constituée notamment de SnO₂, ZnO, ITO, In₂O₃, Cd₂SnO₄,.. ou d'une combinaison de ces oxydes, ayant typiquement une épaisseur de l'ordre de 0,05 à 10 µm. Selon l'invention, le dépôt est effectué par voie chimique, cette expression englobant les procédés en soi physiques mais dans lesquels intervient une réaction chimique.

Avantageusement, le dépôt se fait selon l'une des techniques énumérées ci-après de manière non exhaustive, avec références de la littérature qui les concernent :
- **CVD basse pression (LPCVD):** EP 0 204 563.
- **CVD à pression atmosphérique (APCVD):** "Textured fluorine-doped ZnO films by atmospheric pressure chemical vapor deposition and their use in amorphous silicon solar cells", Jianhua Hu and Roy G. Gordon, Solar Cells, Vol. 30 (1991), p. 437-450.
- **CVD organométallique photo-induit (photo-MOCVD):** "Large area ZnO thin films for solar cells prepared by photo-induced metalorganic chemical vapor deposition" , Masahiro Yoshino, Wilson W. Wenas, Akira Yamada, Makoto Konagai and Kioshi Takahashi, Japanese Journal of Applied Physics, Vol 32 (1993), p.726-730, Part 1, No. 2.
- **Bain chimique solgel (CBD):** "Novel temperature solution deposition of perpendicularly orientated rods of ZnO: substrate effects and evidence of the importance of counter-ions in the control of crystallite growth", David S. Boyle, Kuveshni Govender and Paul O'Brien, Chemical Communications, (2002), p.80-81.
- **Evaporation reactive:** "Preparation and optoelectronic characterization of ZnO thin films deposited by reactive evaporation", G. Gordillo, C. Calderón, J. Olarte, J. Sandino and H. Méndez, Proceedings of the 2nd world conference and exhibition on photovoltaic solar energy conversion, 6-10 July 1998, Vienna, Austria, Thin Film Cells and Technologies, Vol B5 (1998), p. 750-753.
- **CVD par plasma (PECVD):** "Surface texture ZnO films for thin film solar cell applications by expanding thermal plasma CVD", R. Groenen, J. Löffler, P. M. Sommeling, J. L. Linden, E. A. G Hamers, R. E. I Schropp, M. C. M. van de Sanden, Thin Solid Films 392 (2001), p. 226-230. "The effect of substrate temperature and rf power on the growth rate and the orientation of ZnO thin films prepared by plasma enhanced chemical vapor deposition" Young Jin Kim, Hyeong Joon Kim, Materials Letters 21, (1994), p. 351-356.
- **Jet de vapeur:** "Jet vapor déposition of transparent conductive ZnO:Al thin films for photovoltaic applications", H. Han, J.-Z. Zhang, B. L. Halpern, J.J. Schmitt, and J. del Cueto, Material Research Society Proceedings Vol 426, (1997) p. 491-496.
- **Pyrolyse par vaporisation:** "Properties presented by zinc oxide thin films deposited by spray pyrolysis", P. Nunes, E. Fortunato, P. Vilarinho, F. Braz Fernandes, R. Martins, Proceedings of the 16th European Photovoltaic Solar Energy Conference, Glasgow, Vol.1 (2000), p. 899-902.
- **Pulvérisation magnetron RF:** "The fiber texture growth and the surface roughness of ZnO thin films", J. A. Anna Selvan, H. Keppner, U. Kroll, J. Cuperus, A. Shah, T. Adatte and N. Randall, Materials Research Society Proceedings Vol 472 (1997), p. 39-44.

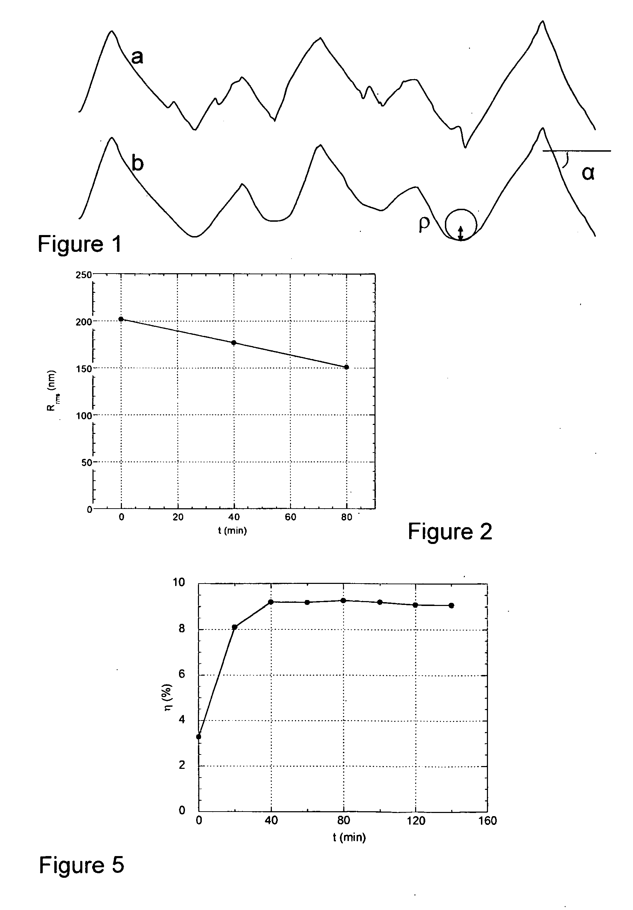

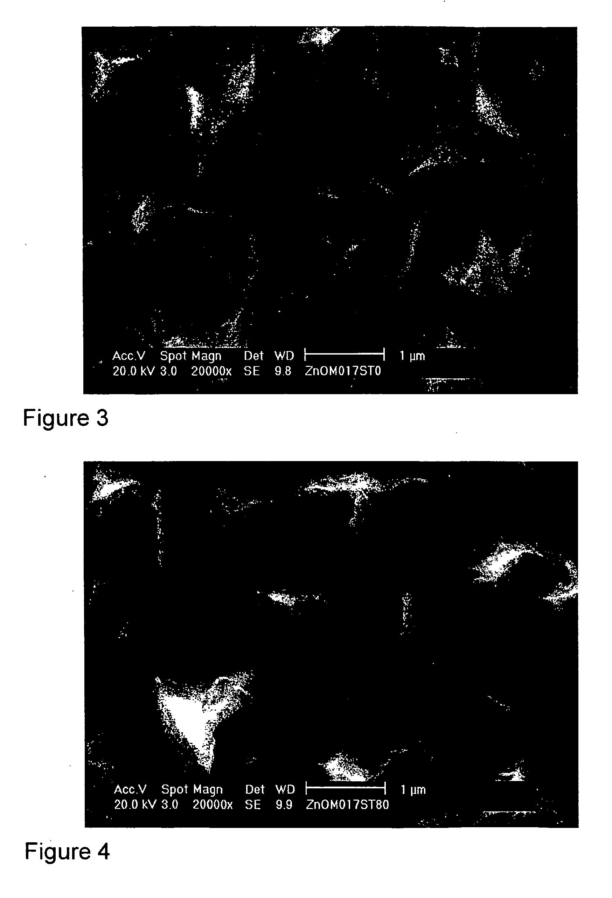

Des mesures, présentées plus loin, démontrent que la couche TCO ainsi obtenue, moyennant un choix judicieux des paramètres de dépôt, possède une excellente capacité de piégeage optique. En revanche, comme le montre le profil (a) de la figure 1 et la vue en plan de la figure 3, cette couche présente une surface très rugueuse faite de bosses et de creux, lesquels sont généralement en forme de V à flancs relativement abrupts. Le rayon de courbure p de ces creux est, typiquement, de quelques nanomètres. Une telle morphologie s'avère inadaptée à une bonne croissance ultérieure, à partir d'elle, de la couche photoélectrique qui permettra d'en faire une cellule solaire ou un photodétecteur à bon rendement de conversion. Notamment, les creux des V sont des endroits propices, lors de la croissance des couches semiconductrices, à l'apparition de fentes ou de craquelures risquant de provoquer des recombinaisons de porteurs et d'autres problèmes électriques (court-circuits,....) qui affectent le rendement de conversion du dispositif.

La rugosité de la couche TCO déposée par voie chimique peut se caractériser par l'écart-type des hauteurs des points constituant sa surface "rms-roughness" dont la valeur, portée sur le graphique de la figure 2, est de 202 nm.

Une telle couche étant mal adaptée, comme déjà mentionné, malgré sa bonne capacité de piégeage optique, à faire croître sur elle une couche photoélectrique, le procédé selon la présente invention corrige cette faiblesse au moyen d'une deuxième opération qui consiste en une attaque de la couche de TCO à l'aide d'un plasma à gaz rare, tel que l'hélium (He), le néon (Ne), l'argon (Ar), le krypton (Kr), le xénon (Xe) et le radon (Rn). Des essais ont aussi montré qu'une simple attaque en atmosphère procurait l'effet désiré. Eventuellement, l'attaque peut se faire en utilisant au moins un autre gaz tel que l'hydrogène (H₂), l'oxygène (O₂), l'azote (N₂), le chlore (Cl₂), le méthane (CH₄), l'eau (H₂O) et le dioxyde de carbone (CO₂). De préférence, l'attaque est réalisée par un plasma d'argon.

Une description de la technique d'attaque par plasma est fournie, par exemple, dans la publication "Effect of high-density plasma etching on the optical properties and surface stoichiometry of ZnO" by K. Ip et al. Applied Physics Letters, vol 81 number 19, p 3546, 2002.

L'équipement utilisé peut être la machine Reactive ion etcher IPL 200E de la firme Integrated Plasma Limited. A titre d'exemple non limitatif, les conditions de l'attaque peuvent être les suivantes :
- Puissance : 1 W/cm²
- Pression : 90 mTor
- Fréquence : 13,56 Mhz
- Température ambiante
- Gaz : argon.

De manière surprenante, ainsi qu'il ressort des mesures effectuées, présentées plus bas, une telle attaque ne réduit pas sensiblement la capacité de piégeage de la couche TCO. En revanche, comme le montrent le profil (b) de la figure 1 et la figure 4, la couche reste rugueuse, ses pointes restent élevées, alors que ses creux prennent une forme de U, avec donc un fond sensiblement plus arrondi que dans le cas de vallées en forme de V. Typiquement, le rayon de courbure p (figure 1) des fonds est supérieur à environ 25 nm. De plus, les fonds sont pratiquement lisses, c'est-à-dire que, s'ils présentent des micro-aspérités, celles-ci ont, en moyenne, une hauteur inférieure à 5 nm et une rugosité de surface, déterminée par l'écart-type des hauteurs des points constituant sa surface, inférieure à 3 nm. Une telle morphologie est idéale pour une bonne croissance ultérieure de la couche photoélectrique qui permettra d'en faire une cellule solaire ou un photodétecteur exempt de craquelures.

Du fait de l'attaque de la couche par plasma, l'écart-type de sa surface "rms-roughness", également porté sur le graphique de la figure 2, est passée de 202 nm à 177nm après 40 minutes et à 151 nm après 80 minutes.

Typiquement, la couche TCO selon l'invention présente encore avantageusement les principales caractéristiques géométriques suivantes :
- ses flancs forment, avec le plan du substrat, un angle α (figure 1) dont la médiane de la valeur absolue est comprise entre 30° et 75° environ ;
- l'écart-type des hauteurs des points constituant sa surface est compris entre 40 et 250 nm environ ;
- l'écart vertical entre ses bosses et ses creux est compris entre 100 et 800 nm environ;
- la distance entre les sommets des bosses est comprise entre 100 et 1500 nm environ.

A propos de l'angle α que forment les flancs de la couche, on notera qu'une valeur inférieure à 30° procure un piégeage optique faible, alors qu'une valeur supérieure à 75° provoque une mauvaise croissance de la couche déposée par la suite.

Ainsi, la couche initiale TCO, déposée par voie chimique, qui présentait une bonne capacité de piégeage optique, mais une morphologie inadaptée à une bonne croissance ultérieure de la couche photoélectrique possède toujours grâce à son attaque par plasma, à la fois une bonne capacité de piégeage et, une morphologie bien adaptée à la croissance de la couche photoélectrique.

On se référera aussi au graphe de la figure 5 qui montre l'amélioration, en fonction de la durée t de l'attaque au plasma, du rendement de conversion η d'un dispositif photoélectrique en silicium microcristallin hydrogéné doté d'un substrat recouvert d'une couche de TCO déposée par voie chimique. Ici, les couches de silicium microcristallin sont déposées par la méthode PECVD (en Anglais : « plasma-enhanced chemical vapour deposition ». Il est à remarquer que la valeur de η avant l'attaque n'est que de 3,3% au départ, mais qu'elle monte à 9,2% après 40 minutes pour rester constante ensuite. Une durée optimale du traitement par plasma dans les conditions d'opération susmentionnées se situe donc aux environ de 40 minutes. L'écart type de la rugosité ne descend alors qu'à une valeur inférieure à 180 nm, encore tout à fait satisfaisante pour un piégeage optimal de la lumière dans la cellule.

Le tableau ci-dessous montre, à titre d'exemple, l'évolution des diverses caractéristiques (déjà mentionnées) d'un dispositif photoélectrique en silicium microcristallin hydrogéné doté d'une couche de TCO déposée par voie chimique avant et après son attaque par plasma.

| | Iᵢₙᵥ (mA/cm²) | ΔIᵢₙᵥ/Iᵢₙᵥ (%) | V_{oc} (mV) | ΔV_{oc}/V_{oc} (%) | FF(%) | ΔFF/FF (%) | η (%) | Δη/η (%) |
|---|---|---|---|---|---|---|---|---|
| Sans trait. | 25.2 | 0 | 441 | 0 | 42.3 | 0 | 3.3 | 0 |
| 40 mn | 25.7 | +2.0 | 528 | +19.7 | 69.2 | +63.6 | 9.2 | +238 |
| 60 mn | 24.9 | -1.2 | 534 | +21.1 | 70.4 | +66.4 | 9.2 | +238 |

On peut faire les remarques suivantes :
- La densité de photo-courant Iᵢₙᵥ fournie sous tension inverse, qui est un indicateur de la capacité de piégeage optique du dispositif, n'est pratiquement pas affectée par l'attaque par plasma.
- La tension de circuit ouvert V_{oc} et le Fill factor FF, qui tous deux contribuent au rendement de conversion du dispositif, sont très fortement améliorés puisqu'après 60 minutes d'attaque, ils font des bonds de 21,1 % et de 66,4% respectivement.
- Enfin, le rendement de conversion η, fait un bond de 238%.

Ce qui précède démontre bien que la combinaison de deux opérations connues en soi, à savoir le dépôt d'une couche TCO par voie chimique puis son attaque à l'aide d'un plasma, permettent de doter un dispositif photoélectrique d'un substrat qui lui conférera un excellent rendement de conversion et une excellente capacité de piégeage optique.

Il faut aussi noter que, du fait de l'attaque par plasma, le rendement de production de la couche obtenue par le procédé selon l'invention est supérieur à 95% alors qu'il est de 60%, en moyenne, lorsqu'on utilise d'autres procédés. Cela est dû au fait que le traitement par plasma élimine de manière efficace toutes les poussières et particules présentes dans l'environnement de travail, qui risqueraient de court-circuiter les cellules.

Bien entendu, tout dispositif photoélectrique en couches minces peut bénéficier du substrat selon l'invention. Il peut donc s'agir, par exemple, d'un des dispositifs suivants :
- cellule solaire en silicium amorphe hydrogéné,
- cellule solaire en silicium microcristallin hydrogéné,
- cellule à couches minces type multijonctions,
- cellule solaire « tandem » comportant une jonction en silicium amorphe et une jonction en silicium microcristallin,
- cellule solaire à tellurure de cadmium,
- cellule solaire à base de chalcopyrite, par exemple avec du Cu(InₓGa₁₋ₓ) Se₂,
- cellule solaire à base d'un alliage amorphe de silicium et germanium,
- cellule solaire organique ou photodétecteur avec un des matériaux précités.

## Revendications

1. Couche conductrice transparente texturée déposée sur un substrat destiné à un dispositif photoélectrique et présentant une morphologie de surface formée d'une alternance de bosses et de creux, **caractérisée en ce que** :
- ses creux ont un fond arrondi dont le rayon est supérieur à 25 nm ;
- lesdits creux sont pratiquement lisses, c'est-à-dire que, s'ils présentent des micro-aspérités, celles-ci ont, en moyenne, une hauteur inférieure à 5 nm ; et
- ses flancs forment, avec le plan du substrat, un angle dont la médiane de la valeur absolue est comprise entre 30° et 75°.

2. Couche conductrice selon la revendication 1, **caractérisée en ce que** sa rugosité, déterminée par l'écart-type des hauteurs des points constituant sa surface, est comprise entre 40 et 250 nm .

3. Couche conductrice selon la revendication 2, **caractérisée en ce que** la rugosité de ses creux, déterminée par l'écart-type des hauteurs des points constituant leur surface, est inférieure à 3 nm.

4. Couche conductrice selon l'une des revendications 1 à 3, **caractérisée en ce que** l'écart entre ses bosses et ses creux est compris entre 100 et 800 nm.

5. Couche conductrice selon l'une des revendications 1 à 4, **caractérisée en ce que** la distance entre les sommets de ses bosses est comprise entre 100 et 1500 nm.

6. Procédé de réalisation, sur un substrat destiné à un dispositif photoélectrique, d'une couche conductrice transparente texturée, **caractérisé en ce qu'**il comporte les opérations essentielles suivantes :
- dépôt sur le substrat, par voie chimique, d'une couche rugueuse diffusant la lumière, et
- attaque de cette couche rugueuse par un plasma de manière à obtenir une couche présentant une morphologie de surface formée d'une alternance de bosses et de creux,
- lesdits creux ayant un fond arrondi dont le rayon est supérieur à 25 nm ;
- lesdits creux étant pratiquement lisses, c'est-à-dire que, s'ils présentent des micro-aspérités, celles-ci ont, en moyenne, une hauteur inférieure à 5 nm ; et
- les flancs de la couche formant, avec le plan du substrat, un angle dont la médiane de la valeur absolue est comprise entre 30° et 75,
afin de conférer à ladite couche une morphologie propice à une bonne croissance ultérieure d'une couche photoélectrique déposée sur elle, sans diminution significative de son pouvoir de diffuser la lumière incidente.

7. Procédé selon la revendication 6, **caractérisé en ce que** l'opération de dépôt par voie chimique se fait par l'une des techniques du groupe comprenant: CVD basse pression (LPCVD), CVD à pression atmosphérique (APCVD), CVD organométallique photo-induit (photo-MOCVD), Bain chimique solgel (CBD), Evaporation réactive, CVD par plasma (PECVD), Jet de vapeur, Pyrolyse par vaporisation et Pulvérisation magnetron RF.

8. Procédé selon l'une des revendications 6 et 7, **caractérisé en ce que** ladite couche comprend un oxyde choisi dans le groupe SnO2, ZnO, ITO, In₂O₃, Cd₂SnO₄, ainsi qu'une combinaison de ces oxydes.

9. Procédé selon l'une des revendications 6 à 8, **caractérisé en ce que** l'opération d'attaque se fait à l'aide d'un plasma à gaz choisi dans le groupe comprenant l'hélium, le néon, l'argon, le krypton, le xénon et le radon.

10. Procédé selon la revendication 9, **caractérisé en ce que** ledit gaz est accompagné d'au moins un autre gaz choisi dans le groupe comprenant l'hydrogène, l'oxygène, l'azote, le chlore, le méthane, l'eau et le dioxyde de carbone.

## Claims

1. Textured transparent conductive layer deposited on a substrate intended for a photoelectric device and having a surface morphology formed from a sequence of humps and hollows, **characterized in that**:
- its hollows have a rounded base, the radius of which is greater than 25 nm;
- said hollows are virtually smooth, which is to say that, where they exhibit microroughnesses, these microroughnesses have an average height of less than 5 nm; and
- its flanks form, with the plane of the substrate, an angle whereof the median of the absolute value is between 30° and 75°.

2. Conductive layer according to claim 1, **characterized in that** its roughness, determined by the standard deviation of the heights of the points constituting its surface, is between 40 and 250 nm.

3. Conductive layer according to claim 2, **characterized in that** the roughness of its hollows, determined by the standard deviation of the heights of the points constituting their surface, is smaller than 3 nm.

4. Conductive layer according to one of claims 1 to 3, **characterized in that** the gap between its humps and its hollows is between 100 and 800 nm.

5. Conductive layer according to one of claims 1 to 4, **characterized in that** the distance between the peaks of its humps is between 100 and 1500 nm.

6. Method for producing, on a substrate intended for a photoelectric device, a textured transparent conductive layer, **characterized in that** it includes the following main operations:
- chemical deposition on the substrate of a rough layer diffusing light, and
- plasma etching of this rough layer so as to obtain a layer having a surface morphology formed from a sequence of humps and hollows,
- said hollows having a rounded base whereof the radius is greater than 25 nm;
- said hollows being virtually smooth, which is to say that, where they exhibit microroughnesses, these microroughnesses have an average height of less than 5 nm; and
- the flanks of the layer forming, with the plane of the substrate, an angle whereof the median of the absolute value is between 30° and 75°,
in order to grant said layer a morphology favorable to a good later growth of a photoelectric layer deposited on it, without significantly decreasing its power to diffuse the incident light.

7. Method according to claim 6, **characterized in that** the chemical deposition operation is done using one of the techniques from the group made up of: low-pressure CVD (LPCVD), atmospheric pressure CVD (APCVD), photo-induced metalorganic CVD (photo-MOCVD), chemical bath deposition (CBD), Reactive evaporation, Plasma-enhanced CVD (PECVD), Vapor jet, Spray pyrolysis and RF magnetron sputtering.

8. Method according to one of claims 6 and 7, **characterized in that** said layer comprises an oxide chosen from the group of SnO₂, ZnO, ITO, In₂O₃, Cd₂SnO₄, as well as a combination of these oxides.

9. Method according to one of claims 6 to 8, **characterized in that** the etching operation is done using a gas plasma chosen from the group including helium, neon, argon, krypton, xenon and radon.

10. Method according to claim 9, **characterized in that** said gas is accompanied by at least one other gas chosen from the group including hydrogen, oxygen, nitrogen, chlorine, methane, water and carbon dioxide.

## Patentansprüche

1. Texturierte transparente leitende Schicht, die auf einem Substrat aufgebracht ist, das für einen photoelektrische Vorrichtung bestimmt ist und eine Oberflächenmorphologie aufweist, die von abwechselnden Erhebungen und Vertiefungen geformt wird, **dadurch gekennzeichnet, dass**:
- ihre Vertiefungen einen abgerundeten Boden haben, dessen Radius größer als 25 nm ist,
- die Vertiefungen praktisch glatt sind, das heißt, dass, wenn sie Mikro-Unebenheiten aufweisen, diese im Durchschnitt eine Höhe von unter 5 nm haben, und
- ihre Seiten mit der Substratebene einen Winkel bilden, dessen Mediane des absoluten Werts zwischen 30° und 75° inklusive ist.

2. Leitende Schicht nach Anspruch 1, **dadurch gekennzeichnet, dass** ihre Rauheit, die durch die Standardabweichung der Höhen der Punkte bestimmt wird, die ihre Oberfläche bilden, zwischen 40 und 250 nm inklusive ist.

3. Leitende Schicht nach Anspruch 2, **dadurch gekennzeichnet, dass** die Rauheit ihrer Vertiefungen, die durch die Standardabweichung der Höhen der Punkte bestimmt wird, die ihre Oberfläche bilden, unter 3 nm ist.

4. Leitende Schicht nach einem der Ansprüche 1 bis 3, **dadurch gekennzeichnet, dass** die Spanne zwischen ihren Erhebungen und ihren Vertiefungen zwischen 100 und 800 nm inklusive ist.

5. Leitende Schicht nach einem der Ansprüche 1 bis 4, **dadurch gekennzeichnet, dass** der Abstand zwischen den Gipfeln ihrer Erhebungen zwischen 100 und 1500 nm inklusive ist.

6. Verfahren zur Herstellung einer texturierten transparenten leitenden Schicht auf einem für eine photoelektrische Vorrichtung bestimmten Substrat, **dadurch gekennzeichnet, dass** es die folgenden wesentlichen Schritte umfasst:
- Aufbringen einer rauen, lichtstreuenden Schicht auf chemischem Weg auf das Substrat,
- Angreifen dieser rauen Schicht durch ein Plasma, um eine Schicht zu erhalten, die eine Oberflächenmorphologie aufweist, die von abwechselnden Erhebungen und Vertiefungen geformt wird, wobei
- die Vertiefungen einen abgerundeten Boden haben, dessen Radius größer als 25 nm ist,
- die Vertiefungen praktisch glatt sind, das heißt, dass, wenn sie Mikro-Unebenheiten aufweisen, diese im Durchschnitt eine Höhe von unter 5 nm haben, und
- die Seiten der Schicht mit der Substratebene einen Winkel bilden, dessen Mediane des absoluten Werts zwischen 30° und 75° inklusive ist,
um der Schicht eine Morphologie zu verleihen, die für ein späteres gutes Wachstum einer auf ihr aufgebrachten photoelektrischen Schicht günstig ist, ohne signifikante Verringerung ihrer Fähigkeit, das einfallende Licht zu streuen.

7. Verfahren nach Anspruch 6, **dadurch gekennzeichnet, dass** der Schritt des Aufbringens auf chemischem Weg anhand einer der Techniken der Gruppe erfolgt, die umfasst: Niederdruck-CVD (LPCVD), Normaldruck-CVD (APCVD), metallorganische lichtinduzierte CVD (MOCVD), chemisches Sol-Gel-Bad (CBD), reaktive Verdampfung, plasmaunterstützte CVD (PECVD), Dampfstrahl, Pyrolyse durch Verdampfung und RF-Magnetron-Pulverisierung.

8. Verfahren nach einem der Ansprüche 6 und 7, **dadurch gekennzeichnet, dass** die Schicht ein Oxid umfasst, das aus der Gruppe Sn02, ZnO, ITO, In2O3, Cd2Sn04 sowie einer Kombination dieser Oxide ausgewählt ist.

9. Verfahren nach einem der Ansprüche 6 bis 8, **dadurch gekennzeichnet, dass** der Schritt des Angreifens mit Hilfe eines Gasplasmas erfolgt, das aus der Gruppe ausgewählt ist, die das Helium, das Neon, das Argon, das Krypton, das Xenon und das Radon umfasst.

10. Verfahren nach Anspruch 9, **dadurch gekennzeichnet, dass** das Gas von mindestens einem anderen Gas begleitet wird, das aus der Gruppe ausgewählt ist, die den Wasserstoff, den Sauerstoff, den Stickstoff, das Chlor, das Methan, das Wasser und das Kohlendioxid umfasst.
